# EUROPEAN PATENT APPLICATION

(11) **EP 4 750 242 A1**
(43) Date of publication of application: **27.05.2026**
(21) Application number: 25216212.8
(22) Date of filing: 17.11.2025
(51) Int. Cl.: H10B 12/00

(54) **SYSTEMS AND METHODS OF GATE FORMATION FOR BITLINE ELECTRIC FIELD REDUCTION**

(30) Priority: 20.11.2024 US 202463723108 P; 03.04.2025 US 202519170056
(71) Applicant: Samsung Electronics Co., Ltd., Suwon-si, Gyeonggi-do 16677 (KR)
(72) Inventor: AGRAWAL, Nidhi, San Jose, CA, 95134 (US); KANAGO, Anthony James, San Jose, CA, 95134 (US); KO, Jung Soo, San Jose, CA, 95134 (US)
(74) Representative: Kuhnen & Wacker Patent- und Rechtsanwaltsbüro PartG mbB

(57) **Abstract**

Provided are systems, methods, and apparatuses for reducing an electric field based on selective thickness of a gate dielectric. In one or more examples, the systems, devices, and methods include forming a first insulator (105), a second insulator, and a semiconductor channel (125) of the transistor; forming a dielectric layer (305) over at least one of a surface of the first insulator (105), a surface of the second insulator (110), or a surface of the semiconductor channel (125); forming a first metal layer (405) over the dielectric layer (305); forming a second metal layer (505) over the first metal layer (405); removing a first portion of the first metal layer (405) and a portion of the second metal layer (505); and forming at least one recess (705, 710, 715, 720, 725, 730) between the second metal layer (505) and the dielectric layer (305) based on removing a second portion of the first metal layer (405).

## Description

### TECHNICAL FIELD

The disclosure relates generally to memory systems. In particular, the subject matter relates to reducing an electric field (e.g., on the bitline side of a transistor) based on systems and methods of forming a thicker gate oxide formation (e.g., on the bitline side of the gate edge).

### BACKGROUND

The present background section is intended to provide context only, and the disclosure of any concept in this section does not constitute an admission that said concept is prior art.

A dynamic random-access memory (DRAM) cell may include a transistor and a capacitor. The transistor can act as a switch, controlling access to the capacitor where a data bit may be stored. The transistor can act as a gate that determines when the capacitor can be accessed to read or write data. When a voltage is applied to the transistor's gate, the transistor turns on, allowing current to flow through the channel and connect the capacitor to the bit line. When the gate voltage is removed, the transistor turns off, isolating the capacitor and preserving the stored charge. Since the capacitor may slowly leak charge over time, the transistor can periodically refresh the data by reading and rewriting the stored value to maintain data integrity.

### SUMMARY

In various embodiments, the systems and methods described herein include systems, methods, and apparatuses for reducing an electric field (e.g., on the bitline side) based on forming a thicker gate dielectric formation (e.g., on the bitline side of the gate edge). In some aspects, the techniques described herein relate to a method of fabrication of a transistor of a memory cell, the method including: forming a first insulator, a second insulator, and a semiconductor channel of the transistor; forming a dielectric layer over at least one of a surface of the first insulator, a surface of the second insulator, or a surface of the semiconductor channel; forming a first metal layer over the dielectric layer; forming a second metal layer over the first metal layer; removing a first portion of the first metal layer and a portion of the second metal layer; and forming at least one recess between the second metal layer and the dielectric layer based on removing a second portion of the first metal layer.

In some aspects, the techniques described herein relate to a method, wherein the at least one recess includes a first recess formed between an exposed surface of the second metal layer and a first portion of the dielectric layer formed over a first inter-tier dielectric that extends out from a first portion of the first insulator.

In some aspects, the techniques described herein relate to a method, wherein the at least one recess includes at least one of: a second recess formed between an exposed surface of the second metal layer and a second portion of the dielectric layer formed over the semiconductor channel, and a third recess formed between an exposed surface of the second metal layer and a third portion of the dielectric layer formed over a second inter-tier dielectric that extends out from a second portion of the first insulator. In some aspects, the techniques described herein relate to a method, wherein forming the second metal layer includes a deposition fill that fills multiple gaps with the second metal layer.

In some aspects, the techniques described herein relate to a method, wherein the multiple gaps include a first gap above a first inter-tier dielectric, a second gap between the first inter-tier dielectric and the semiconductor channel, a third gap between the semiconductor channel and a second inter-tier dielectric, and a fourth gap below the second inter-tier dielectric.

In some aspects, the techniques described herein relate to a method, wherein the dielectric layer is formed as a gate oxide of the transistor. In some aspects, the techniques described herein relate to a method, further including forming a capping insulator material over the first metal layer, the second metal layer, and the dielectric layer, the capping insulator material filling the at least one recess.

In some aspects, the techniques described herein relate to a method, wherein at least one of the capping insulator material, the first insulator, or the second insulator include at least one of a nitride insulator or an oxide insulator. In some aspects, the techniques described herein relate to a method, wherein forming the first metal layer includes forming a thin layer of the first metal layer over the dielectric layer, at least one of the dielectric layer or the first metal layer having a thickness within a range of 0.5 nanometers (nm) to 20 nm.

In some aspects, the techniques described herein relate to a method, wherein at least a portion of the second insulator is formed adjacent to the first insulator and a semiconductor that includes the semiconductor channel.

In some aspects, the techniques described herein relate to a transistor of a memory cell including: a first insulator, a second insulator, and a semiconductor channel; a dielectric layer formed over at least one of a surface of the first insulator, a surface of the second insulator, or a surface of the semiconductor channel; a first metal layer formed over the dielectric layer; a second metal layer formed over the first metal layer; at least one gap formed based on a first etch back of a first portion of the first metal layer and a portion of the second metal layer; and at least one recess formed between the second metal layer and the dielectric layer based on a second etch back of a second portion of the first metal layer.

In some aspects, the techniques described herein relate to a transistor, wherein the at least one recess includes a first recess formed between an exposed surface of the second metal layer and a first portion of the dielectric layer formed over a first inter-tier dielectric that extends out from a first portion of the first insulator.

In some aspects, the techniques described herein relate to a transistor, wherein the at least one recess includes at least one of: a second recess formed between an exposed surface of the second metal layer and a second portion of the dielectric layer formed over the semiconductor channel, and a third recess formed between an exposed surface of the second metal layer and a third portion of the dielectric layer formed over a second inter-tier dielectric that extends out from a second portion of the first insulator. In some aspects, the techniques described herein relate to a transistor, wherein formation of the second metal layer includes a deposition fill that fills the at least one gap with the second metal layer.

In some aspects, the techniques described herein relate to a transistor, wherein the at least one gap includes a first gap above a first inter-tier dielectric, a second gap between the first inter-tier dielectric and the semiconductor channel, a third gap between the semiconductor channel and a second inter-tier dielectric, and a fourth gap below the second inter-tier dielectric.

In some aspects, the techniques described herein relate to a transistor, wherein the dielectric layer is formed as a gate oxide of the transistor. In some aspects, the techniques described herein relate to a transistor, wherein the transistor further includes a capping insulator material formed over the first metal layer, the second metal layer, and the dielectric layer, the capping insulator material filling the at least one recess.

In some aspects, the techniques described herein relate to a fabrication system including: a deposition controller to: form a first insulator, a second insulator, and a semiconductor channel of a transistor; form a dielectric layer over at least one of a surface of the first insulator, a surface of the second insulator, or a surface of the semiconductor channel; form a first metal layer over the dielectric layer; and form a second metal layer over the first metal layer; and a removal controller to: remove a first portion of the first metal layer and a portion of the second metal layer; and remove a second portion of the first metal layer, forming at least one recess between the second metal layer and the dielectric layer.

In some aspects, the techniques described herein relate to a fabrication system, wherein the at least one recess includes a first recess formed between an exposed surface of the second metal layer and a first portion of the dielectric layer formed over a first inter-tier dielectric that extends out from a first portion of the first insulator.

In some aspects, the techniques described herein relate to a fabrication system, wherein the at least one recess includes at least one of: a second recess formed between an exposed surface of the second metal layer and a second portion of the dielectric layer formed over the semiconductor channel, and a third recess formed between an exposed surface of the second metal layer and a third portion of the dielectric layer formed over a second inter-tier dielectric that extends out from a second portion of the first insulator.

A computer-readable medium is disclosed. The computer-readable medium can store instructions that, when executed by a computer, cause the computer to perform substantially the same or similar operations as described herein are further disclosed. Similarly, non-transitory computer-readable media, devices, and systems for performing substantially the same or similar operations as described herein are further disclosed.

The systems and methods described herein include multiple advantages and benefits. For example, the systems and methods described herein can form a thicker gate dielectric relatively near a gate edge (e.g., gate edge on the bitline side) of a transistor (e.g., transistor of 3D DRAM). The systems and methods described herein can reduce the electric field near the bitline side channel of the transistor, thus reducing leakage based on a bitline gate-induced drain leakage (GIDL).

### BRIEF DESCRIPTION OF THE DRAWINGS

The above-mentioned aspects and other aspects of the present systems and methods will be better understood when the present application is read in view of the following figures in which like numbers indicate similar or identical elements. Further, the drawings provided herein are for purpose of illustrating certain embodiments only; other embodiments, which may not be explicitly illustrated, are not excluded from the scope of this disclosure.

These and other features and advantages of the present disclosure will be appreciated and understood with reference to the specification, claims, and appended drawings, wherein:
FIG. 1 illustrates a cross-sectional view illustrating an example of a semiconductor device in accordance with one or more implementations as described herein.
FIG. 2 illustrates a three-dimensional view illustrating an example of a semiconductor device in accordance with one or more implementations as described herein.
FIG. 3 illustrates a cross-sectional view illustrating an example of a semiconductor device in accordance with one or more implementations as described herein.
FIG. 4 illustrates a cross-sectional view illustrating an example of a semiconductor device in accordance with one or more implementations as described herein.
FIG. 5 illustrates a cross-sectional view illustrating an example of a semiconductor device in accordance with one or more implementations as described herein.
FIG. 6 illustrates a cross-sectional view illustrating an example of a semiconductor device in accordance with one or more implementations as described herein.
FIG. 7 illustrates a cross-sectional view illustrating an example of a semiconductor device in accordance with one or more implementations as described herein.
FIG. 8 illustrates a cross-sectional view illustrating an example of a semiconductor device in accordance with one or more implementations as described herein.
FIG. 9 depicts a flow diagram illustrating an example method associated with the disclosed systems, in accordance with example implementations described herein.
FIG. 10 depicts a flow diagram illustrating an example method associated with the disclosed systems, in accordance with example implementations described herein.
FIG. 11 illustrates an example system in accordance with one or more implementations as described herein.

While the present systems and methods are susceptible to various modifications and alternative forms, specific embodiments thereof are shown by way of example in the drawings and will herein be described. The drawings may not be to scale. It should be understood, however, that the drawings and detailed description thereto are not intended to limit the present systems and methods to the particular form disclosed, but to the contrary, the intention is to cover all modifications, equivalents, and alternatives falling within the scope of the present systems and methods as defined by the appended claims.

### DETAILED DESCRIPTION OF VARIOUS EMBODIMENTS

The details of one or more embodiments of the subject matter described herein are set forth in the accompanying drawings and the description below. Other features, aspects, and advantages of the subject matter will become apparent from the description, the drawings, and the claims.

Various embodiments of the present disclosure now will be described more fully hereinafter with reference to the accompanying drawings, in which some, but not all embodiments are shown. Indeed, the disclosure may be embodied in many forms and should not be construed as limited to the embodiments set forth herein; rather, these embodiments are provided so that this disclosure will satisfy applicable legal requirements. The term "or" is used herein in both the alternative and conjunctive sense, unless otherwise indicated. The terms "illustrative" and "example" are used to be examples with no indication of quality level. Like numbers refer to like elements throughout. Arrows in each of the figures depict bi-directional data flow and/or bi-directional data flow capabilities. The terms "path," "pathway" and "route" are used interchangeably herein.

Embodiments of the present disclosure may be implemented in various ways, including as computer program products that comprise articles of manufacture. A computer program product may include a non-transitory computer-readable storage medium storing applications, programs, program components, scripts, source code, program code, object code, byte code, compiled code, interpreted code, machine code, executable instructions, and/or the like (also referred to herein as executable instructions, instructions for execution, computer program products, program code, and/or similar terms used herein interchangeably). Such non-transitory computer-readable storage media includes all computer-readable media (including volatile and non-volatile media).

In one embodiment, a non-volatile computer-readable storage medium may include a floppy disk, flexible disk, hard disk, solid-state storage (SSS) (for example a solid-state drive (SSD)), solid state card (SSC), solid state module (SSM), enterprise flash drive, magnetic tape, or any other non-transitory magnetic medium, and/or the like. A non-volatile computer-readable storage medium may include a punch card, paper tape, optical mark sheet (or any other physical medium with patterns of holes or other optically recognizable indicia), compact disc read only memory (CD-ROM), compact disc-rewritable (CD-RW), digital versatile disc (DVD), Blu-ray disc (BD), any other non-transitory optical medium, and/or the like. Such a non-volatile computer-readable storage medium may include read-only memory (ROM), programmable read-only memory (PROM), erasable programmable read-only memory (EPROM), electrically erasable programmable read-only memory (EEPROM), flash memory (for example Serial, NAND, NOR, and/or the like), multimedia memory cards (MMC), secure digital (SD) memory cards, SmartMedia cards, CompactFlash (CF) cards, Memory Sticks, and/or the like. Further, a non-volatile computer-readable storage medium may include conductive-bridging random access memory (CBRAM), phase-change random access memory (PRAM), ferroelectric random-access memory (FeRAM), non-volatile random-access memory (NVRAM), magnetoresistive random-access memory (MRAM), resistive random-access memory (RRAM), Silicon-Oxide-Nitride-Oxide-Silicon memory (SONOS), floating junction gate random access memory (FJG RAM), Millipede memory, racetrack memory, and/or the like.

In one embodiment, a volatile computer-readable storage medium may include random access memory (RAM), dynamic random access memory (DRAM), static random access memory (SRAM), fast page mode dynamic random access memory (FPM DRAM), extended data-out dynamic random access memory (EDO DRAM), synchronous dynamic random access memory (SDRAM), double data rate synchronous dynamic random access memory (DDR SDRAM), double data rate type two synchronous dynamic random access memory (DDR2 SDRAM), double data rate type three synchronous dynamic random access memory (DDR3 SDRAM), Rambus dynamic random access memory (RDRAM), Twin Transistor RAM (TTRAM), Thyristor RAM (T-RAM), Zero-capacitor (Z-RAM), Rambus in-line memory component (RIMM), dual in-line memory component (DIMM), single in-line memory component (SIMM), video random access memory (VRAM), cache memory (including various levels), flash memory, register memory, and/or the like. It will be appreciated that where embodiments are described to use a computer-readable storage medium, other types of computer-readable storage media may be substituted for or used in addition to the computer-readable storage media described above.

As should be appreciated, various embodiments of the present disclosure may be implemented as methods, apparatuses, systems, computing devices, computing entities, and/or the like. As such, embodiments of the present disclosure may take the form of an apparatus, system, computing device, computing entity, and/or the like executing instructions stored on a computer-readable storage medium to perform certain steps or operations. Thus, embodiments of the present disclosure may take the form of a hardware embodiment, a computer program product embodiment, and/or an embodiment that comprises a combination of computer program products and hardware performing certain steps or operations.

Embodiments of the present disclosure are described below with reference to block diagrams and flowchart illustrations. Thus, it should be understood that each block of the block diagrams and flowchart illustrations may be implemented in the form of a computer program product, a hardware embodiment, a combination of hardware and computer program products, and/or apparatus, systems, computing devices, computing entities, and/or the like carrying out instructions, operations, steps, and similar words used interchangeably (for example the executable instructions, instructions for execution, program code, and/or the like) on a computer-readable storage medium for execution. For example, retrieval, loading, and execution of code may be performed sequentially, such that one instruction is retrieved, loaded, and executed at a time. In some example embodiments, retrieval, loading, and/or execution may be performed in parallel, such that multiple instructions are retrieved, loaded, and/or executed together. Thus, such embodiments can produce specifically configured machines performing the steps or operations specified in the block diagrams and flowchart illustrations. Accordingly, the block diagrams and flowchart illustrations support various combinations of embodiments for performing the specified instructions, operations, or steps.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not be necessarily all referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms, and a plural term may include the corresponding singular form. Similarly, a hyphenated term (e.g., "two-dimensional," "pre-determined," "pixel-specific," etc.) may be occasionally interchangeably used with a corresponding non-hyphenated version (e.g., "two dimensional," "predetermined," "pixel specific," etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other.

Also, depending on the context of discussion herein, a singular term may include the corresponding plural forms, and a plural term may include the corresponding singular form. It is further noted that various figures (including component diagrams) shown and discussed herein are for illustrative purpose only, and are not drawn to scale. Similarly, various waveforms and timing diagrams are shown for illustrative purpose only. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, the term "module" refers to any combination of software, firmware and/or hardware configured to provide the functionality described herein in connection with a module. For example, software may be embodied as a software package, code and/or instruction set or instructions, and the term "hardware," as used in any implementation described herein, may include, for example, singly or in any combination, an assembly, hardwired circuitry, programmable circuitry, state machine circuitry, and/or firmware that stores instructions executed by programmable circuitry. The modules may, collectively or individually, be embodied as circuitry that forms part of a larger system, for example, but not limited to, an integrated circuit (IC), system on chip (SoC), an assembly, and so forth.

The provided description is presented to enable one of ordinary skill in the art to make and use the subject matter disclosed herein and to incorporate it in the context of particular applications. While the following is directed to specific examples, other and further examples may be devised without departing from the basic scope thereof.

Various modifications, as well as a variety of uses in different applications, will be readily apparent to those skilled in the art, and the general principles defined herein may be applied to a wide range of embodiments. Thus, the subject matter disclosed herein is not intended to be limited to the embodiments presented, but is to be accorded the widest scope consistent with the principles and novel features disclosed herein.

In the description provided, numerous specific details are set forth in order to provide a more thorough understanding of the subject matter disclosed herein. It will, however, be apparent to one skilled in the art that the subject matter disclosed herein may be practiced without necessarily being limited to these specific details. In other instances, well-known structures and devices are shown in block diagram form, rather than in detail, in order to avoid obscuring the subject matter disclosed herein.

All the features disclosed in this specification (e.g., any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Various features are described herein with reference to the figures. It should be noted that the figures are only intended to facilitate the description of the features. The various features described are not intended as an exhaustive description of the subject matter disclosed herein or as a limitation on the scope of the subject matter disclosed herein. Additionally, an illustrated example need not have all the aspects or advantages shown. An aspect or an advantage described in conjunction with a particular example is not necessarily limited to that example and can be practiced in any other examples even if not so illustrated, or if not so explicitly described.

It is noted that, if used, the labels left, right, front, back, top, bottom, forward, reverse, clockwise and counterclockwise have been used for convenience purposes only and are not intended to imply any particular fixed direction. Instead, the labels are used to reflect relative locations and/or directions between various portions of an object.

Moreover, the terms "system," "component," "module," "interface," "model," or the like are generally intended to refer to a computer-related entity, either hardware, a combination of hardware and software, software, or software in execution. For example, a component may be, but is not limited to being, a process running on a processor, a processor, an object, an executable, a thread of execution, a program, and/or a computer. By way of illustration, both an application running on a controller and the controller can be a component. One or more components may reside within a process and/or thread of execution and a component may be localized on one computer and/or distributed between two or more computers.

Unless explicitly stated otherwise, each numerical value and range may be interpreted as being approximate, as if the word "about" or "approximately" preceded the value of the value or range. Signals and corresponding nodes or ports might be referred to by the same name and are interchangeable for purposes here.

While embodiments may have been described with respect to circuit functions, the embodiments of the subject matter disclosed herein are not limited. Possible implementations may be embodied in a single integrated circuit, a multi-chip module, a single card, SoC, or a multi-card circuit pack. As would be apparent to one skilled in the art, the various embodiments might also be implemented as part of a larger system. Such embodiments may be employed in conjunction with, for example, a digital signal processor, microcontroller, field-programmable gate array, application-specific integrated circuit, or general-purpose computer.

As would be apparent to one skilled in the art, various functions of circuit elements may also be implemented as processing blocks in a software program. Such software may be employed in, for example, a digital signal processor, microcontroller, or general-purpose computer. Such software may be embodied in the form of program code embodied in tangible media, such as magnetic recording media, optical recording media, solid-state memory, floppy diskettes, CD-ROMs, hard drives, or any other non-transitory machine-readable storage medium, that when the program code is loaded into and executed by a machine, such as a computer, the machine becomes an apparatus for practicing the subject matter disclosed herein. When implemented on a general-purpose processor, the program code segments combine with the processor to provide a unique device that operates analogously to specific logic circuits. Described embodiments may also be manifest in the form of a bit stream or other sequence of signal values electrically or optically transmitted through a medium, stored magnetic-field variations in a magnetic recording medium, etc., generated using a method and/or an apparatus as described herein.

The systems and methods described herein may incorporate and/or may be based on 3D DRAM. A memory cell of DRAM may include one capacitor and one transistor. A DRAM cell's semiconductor architecture generally consists of an access transistor (typically a MOSFET) and a capacitor, arranged in a dense, integrated circuit. The capacitor, which stores the charge representing a binary bit, is fabricated with special materials and designed to maximize its capacitance within a tiny area. The transistor functions as a switch, with its gate connected to a word line and its source/drain regions linked to a bit line. This configuration enables external control circuitry to either charge the capacitor to write a '1' or discharge it to write a '0', while also allowing for the detection of its charge the capacitor to write a '1' or discharge it to write a '0', while also allowing for the detection of its charge state during a read operation. A planar DRAM may include a two-dimensional area of such memory cells (e.g., memory cells formed in an X dimension and Y dimension). 3D DRAM may extend memory cells in a third dimension, or vertically relative to the two-dimensions of planar DRAM. For example, 3D DRAM may form memory cells in an X dimension, Y dimension, and Z dimension. Thus, 3D DRAM can refer to a type of DRAM where the memory cells are stacked vertically on top of each other, allowing for significantly higher storage density compared to planar DRAM by utilizing the third dimension to increase data storage capacity. Higher-density DRAMs provide more memory per watt, which helps datacenters with power consumption and heat dissipation.

The systems and methods described herein may be based on reducing an electric field (e.g., on the bitline side) by forming a relatively small portion of channel near the bitline (BL) side with a thicker oxide as compared to gate oxide on a remaining portion of the channel region. Aspects of the systems and methods described herein may be based on multiple gate metal deposition (e.g., tungsten (W) on titanium nitride (TiN) metal deposition), metal etch back, depositing capping material, etc.

The systems and methods described herein may incorporate and/or may be based on thin metal deposition (e.g., thin TiN deposition), a metal fill (e.g., tungsten (W) deposition fill), a bilayer metal etch back (e.g., etch back of TiN and W), a selective etch back (e.g., etch back of TiN only), and a capping material (e.g., nitride capping). The systems and methods described herein can form thicker gate-oxide close to a bitline side gate edge of a transistor (e.g., transistor of 3D DRAM). The systems and methods described herein can reduce the electric field near the bitline side channel of the transistor, thus reducing leakage based on a bitline gate-induced drain leakage (GIDL).

In computer architecture, deposition can include a fabrication process that involves applying thin layers of materials to a wafer. The quality of deposition can be determined by the uniformity and thinness of the film. The deposition process may include a thin film of a given substance being applied onto the surface of a wafer, giving the wafer electrical characteristics. The process can involve applying multiple layers of a material at the molecular and/or atomic level onto a wafer. For example, deposition can include applying multiple layers of a material at the atomic or molecular level. The types of techniques used can depend on the chip type, the process node, the amount of time used for deposition, etc. Some techniques used in deposition include physical vapor deposition (PVD) to deposit metal films without a chemical reaction; chemical vapor deposition (CVD), using external energy to apply thin films to semiconductors, insulators, and conductors; electrochemical deposition (ECD) to create copper wiring that links devices in an integrated circuit; atomic layer deposition (ALD) to add a few layers of atoms at a time, and the like.

The systems and methods described herein may incorporate and/or may be based on a tungsten-titanium-nitride (W-TiN) metal gate. A W-TiN metal gate can refer to a type of gate electrode used in semiconductor devices (e.g., in transistors, transistors of 3D DRAM), where the gate material may include a stacked layer of W over a layer of TiN. A W-TiN metal gate can include a bilayer metal structure that can be used to control the flow of current in the transistor channel. The gate may be considered a metal gate because the conducting material can include a metal, such as tungsten, unlike some technologies that may use polysilicon as the gate material.

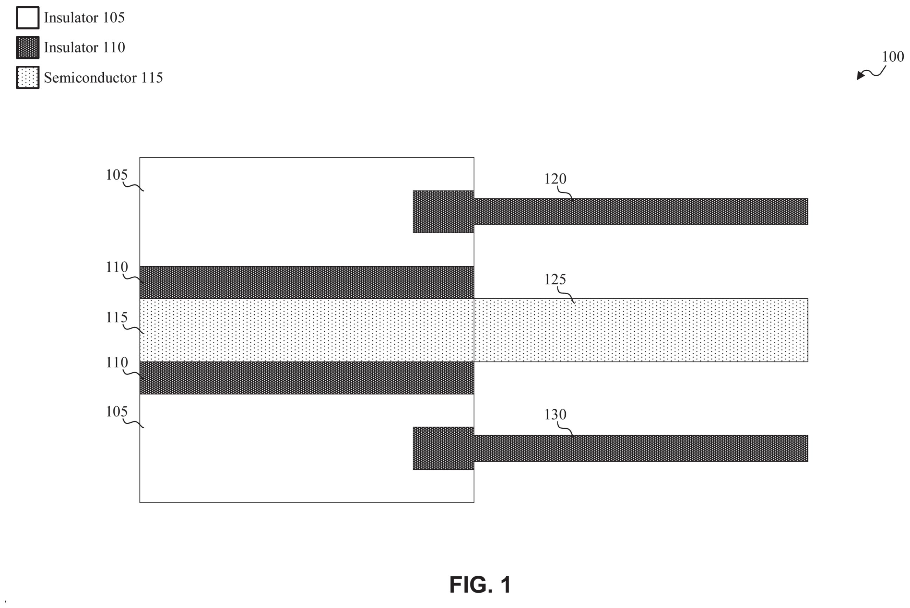

**FIG. 1** illustrates a cross-sectional view illustrating an example of a device 100 (e.g., semiconductor device) in accordance with one or more implementations as described herein. FIG. 1 illustrates at least a portion of a semiconductor device fabrication process resulting in an improved memory cell transistor structure, enabling the systems and methods described herein of reducing an electric field (e.g., on the bitline side of a transistor) based on a thicker gate oxide formation (e.g., on the bitline side of the gate edge). In some cases, device 100 may depict a gate oxide pre-clean stage. In some cases, FIG. 1 may depict a cross-section (e.g., slice view) of elements of device 100 (e.g., elements of a transistor fabrication). Thus, the depicted elements may extend outward and/or may extend inward from the depicted view. Similarly, the depicted elements may repeat themselves upward and/or may repeat themselves downward from the depicted view.

The configuration of device 100 may enable formation of a gate around a semiconductor channel (e.g., semiconductor 115) to form a transistor. In the illustrated example, device 100 may include insulator 105 (e.g., a first spacer insulator such as a nitride insulator and/or oxide insulator), insulator 110 (e.g., a second spacer insulator such as an oxide insulator and/or nitride insulator), and semiconductor 115 (e.g., silicon channel). As shown, device 100 may include inter-tier dielectric 120 and inter-tier dielectric 130. In some cases, inter-tier dielectric 120 and inter-tier dielectric 130 may separate wordlines above and/or below the depicted portion of device 100. As shown, semiconductor 115 may include a semiconductor channel 125, which may include an extension of material (e.g., extension of silicon). Although a line is depicted between semiconductor 115 and semiconductor channel 125, semiconductor channel 125 and semiconductor 115 may include a continuous segment of semiconductive material (e.g., silicon).

The gate oxide pre-clean stage may depict a dual-insulator configuration. In some examples, insulator 105 may include a nitride insulator and/or an oxide insulator. For example, at least a portion of insulator 105 may use a nitride insulator. Additionally, or alternatively, at least a portion of insulator 105 may use an oxide insulator. In some cases, insulator 110 may include an oxide insulator and/or a nitride insulator. For example, at least a portion of insulator 110 may use a nitride insulator. Additionally, or alternatively, at least a portion of insulator 110 may use an oxide insulator.

In some examples, the depicted gate oxide pre-clean stage of device 100 may include spacer materials, such as insulator 105 and/or insulator 110. In some cases, the spacer materials may include a first insulator and/or a second insulator, which may include at least one of a nitride insulator or an oxide insulator (e.g., first insulator includes a nitride insulator, second insulator includes an oxide insulator, or vice versa). The spacer material of insulator 105 and/or insulator 110 may include at least one insulator material, such as silicon nitride (SiN), silicon oxycarbide (SiOC), silicon dioxide (SiO2), etc. In some examples, insulator 105 and/or insulator 110 may include a nitride insulator, which may include silicon nitride, gallium nitride, aluminum nitride, boron nitride, etc. Additionally, or alternatively, insulator 105 and/or insulator 110 may include an oxide insulator, which may include silicon dioxide, aluminum oxide (Al2O3), hafnium oxide (HfO2), titanium dioxide (TiO2), etc.

In some cases, a transistor and capacitor may be formed on a semiconductor channel (e.g., semiconductor 115, silicon channel). In some cases, a transistor may be fabricated in the open areas between inter-tier dielectric 120, semiconductor channel 125, and/or inter-tier dielectric 130, whereas a capacitor may be fabricated in the area between two portions of insulator 110 (e.g., semiconductor 115). Based on the systems and methods described herein, isolation may be formed between semiconductor channel layers to enable each transistor to be accessed independently. A capacitor may be formed on the left side of device 100 based on the depicted view. In some cases, device 100 may include multiple semiconductor channel layers (e.g., from 50 to 300 layers in the vertical direction relative to the depicted view). In some cases, a first semiconductor channel layer of device 100 (e.g., semiconductor 115) and a second semiconductor channel layer of device 100 may be around 50 nanometers (nm) to 200 nm apart. Examples of semiconductor 115 may include at least one of silicon, gallium, germanium, arsenide, etc. In some cases, a semiconductor of device 100 may be doped with impurities to create n-type (electron-rich) and/or p-type (hole-rich) semiconductors.

In some cases, one or more materials of device 100 may be formed based on deposition. In semiconductor chip manufacturing, deposition can include a fabrication process that involves applying thin layers of materials (e.g., over inter-tier dielectric 120, inter-tier dielectric 130, and/or semiconductor channel 125). Deposition can include applying layers of a material at the atomic or molecular level. The type of technique used depends on the chip type, the process node, and the amount of time needed for deposition. Some techniques used in deposition may include: physical vapor deposition (PVD) to deposit metal films without a chemical reaction, chemical vapor deposition (CVD) using external energy to apply thin films to semiconductors, insulators, and conductors, electrochemical deposition (ECD) to create metal wirings (e.g., copper wirings) that links devices in an integrated circuit, atomic layer deposition (ALD) to add layers of atoms at a time, and so on.

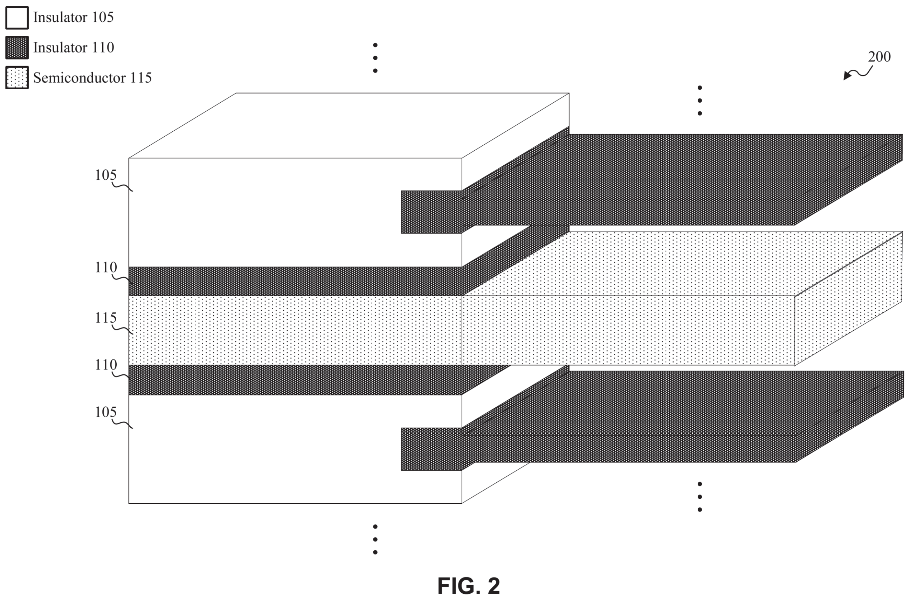

**FIG. 2** illustrates a three-dimensional view illustrating an example of a device 200 (e.g., a semiconductor device) in accordance with one or more implementations as described herein. FIG. 2 illustrates at least a portion of a semiconductor device fabrication process resulting in an improved memory cell transistor structure, enabling the systems and methods described herein of reducing an electric field (e.g., on the bitline side of a transistor) based on a thicker gate oxide formation (e.g., on the bitline side of the gate edge). In the illustrated example, device 200 may be based on device 100 of FIG. 1. In some cases, FIG. 2 may depict a cross-section (e.g., slice view) of elements of device 200 (e.g., elements of a transistor fabrication). Thus, the depicted elements may extend outward and/or may extend inward from the depicted view with some inter-layer dielectric separating the left side of semiconductor 115 (e.g., where a capacitor element may be added). Similarly, the depicted elements may repeat themselves upward and/or may repeat themselves downward from the depicted view.

In the illustrated example, device 200 may depict a three-dimensional view of device 100 of FIG. 1. It is noted that the three-dimensional view of device 200 may apply to the depicted cross-sectional view of one or more of the devices described and/or depicted herein. As shown, insulator 105 may include a block from which extends an upward portion of insulator 110 (not shown in FIG. 2). A second portion of insulator 110 (shown in FIG. 2) may be positioned between insulator 105 and semiconductor 115. A third portion of insulator 110 (shown in FIG. 2) may be positioned between semiconductor 115 and a second block of insulator 105, from which extends downward a portion of insulator 110 (not shown in FIG. 2). In some cases, device 200 may continue with additional elements or layers above and/or additional elements or layers below with respect to the perspective view of device 200.

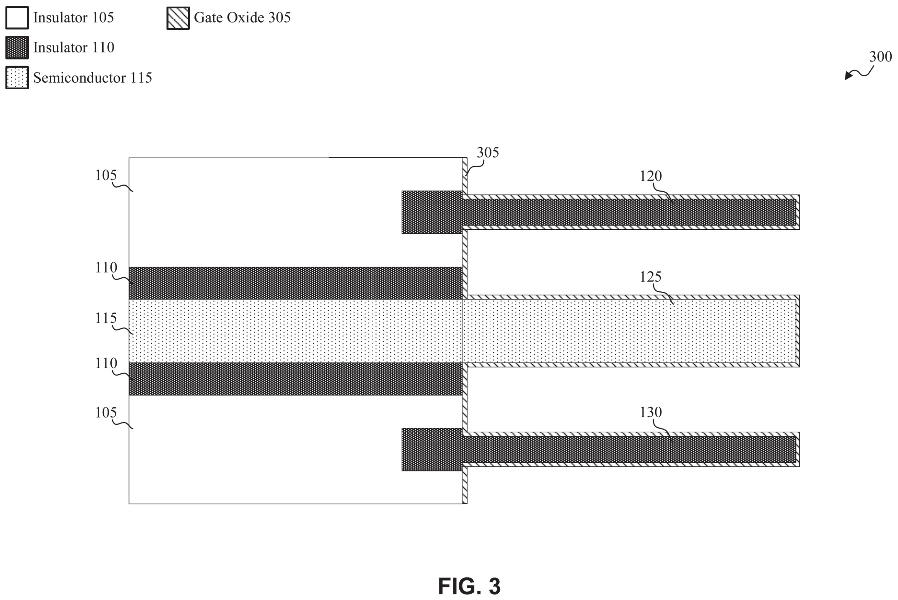

**FIG. 3** illustrates a cross-sectional view illustrating an example of a device 300 (e.g., a semiconductor device) in accordance with one or more implementations as described herein. FIG. 3 illustrates at least a portion of a semiconductor device fabrication process resulting in an improved memory cell transistor structure, enabling the systems and methods described herein of reducing an electric field (e.g., on the bitline side of a transistor) based on a thicker gate oxide formation (e.g., on the bitline side of the gate edge). In the illustrated example, device 300 may be based on device 200 of FIG. 2. In some cases, FIG. 3 may depict a cross-section (e.g., slice view) of elements of device 300 (e.g., elements of a transistor fabrication). Thus, the depicted elements may extend outward and/or may extend inward from the depicted view. Similarly, the depicted elements may repeat themselves upward and/or may repeat themselves downward from the depicted view.

In the illustrated example, device 300 may include gate oxide 305. In some cases, device 300 may depict a deposition of gate oxide 305 over one or more elements of device 100 or device 200 (e.g., over insulator 105, insulator 110, inter-tier dielectric 120, semiconductor channel 125, inter-tier dielectric 130). In some cases, gate oxide 305 may range from 0.5 nm to 20 nm in thickness. In some cases, a thickness of insulator 110, inter-tier dielectric 120, and/or inter-tier dielectric 130 may range from 0.5 nm to 20nm. In some examples, a thickness of semiconductor channel 125 may range from 0.5 nm to 100 nm.

Although device 300 depicts forming a gate dielectric based on gate oxide 305, gate oxide 305 may include any insulator material (e.g., any compatible gate oxide insulator material). For example, gate oxide 305 may include silicon oxycarbide, silicon dioxide, aluminum oxide, hafnium oxide, titanium dioxide, etc. In some cases, gate oxide 305 may include any material with a relatively high dielectric constant (e.g., high-κ dielectric), or any gate oxide insulator material that forms a compatible interface with a semiconductor, such as semiconductor 115 (e.g., silicon).

A capacitor may be formed to the left of the depicted device 300. The level or degree to which data may be retained in the capacitor may be based on the leakage rate. Leakage of data can occur from the capacitor towards the transistor side (e.g., towards the depicted portion of device 300, towards semiconductor 115, semiconductor channel 125, etc.). The higher the rate of leakage, the more often the capacitors must be refreshed to maintain data integrity. However, refresh operations in DRAM can negatively impact performance and power dissipation by requiring periodic cycles where a portion of the memory is unavailable for data access while the stored charges are being replenished, leading to potential stalls in memory requests and consuming additional power to perform the refresh operation. Thus, the more frequent the refresh cycles, the greater the performance penalty and power consumption.

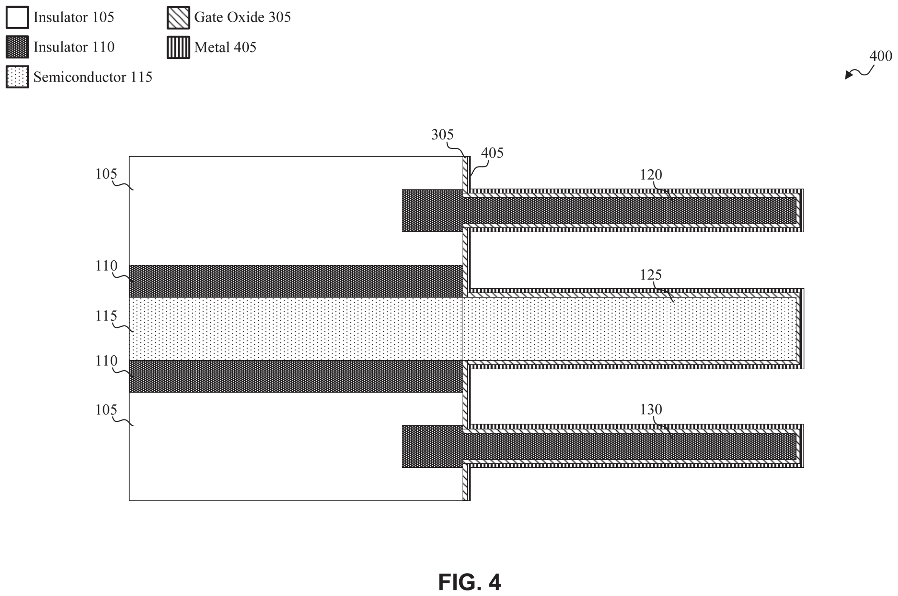

**FIG. 4** illustrates a cross-sectional view illustrating an example of a device 400 (e.g., a semiconductor device) in accordance with one or more implementations as described herein. FIG. 4 illustrates at least a portion of a semiconductor device fabrication process resulting in an improved memory cell transistor structure, enabling the systems and methods described herein of reducing an electric field (e.g., on the bitline side of a transistor) based on a thicker gate oxide formation (e.g., on the bitline side of the gate edge). In the illustrated example, device 400 may be based on device 300 of FIG. 3. In some cases, FIG. 4 may depict a cross-section (e.g., slice view) of elements of device 400 (e.g., elements of a transistor fabrication). Thus, the depicted elements may extend outward and/or may extend inward from the depicted view. Similarly, the depicted elements may repeat themselves upward and/or may repeat themselves downward from the depicted view.

In the illustrated example, device 400 may include metal 405 (e.g., a barrier metal). For example, device 400 may depict a thin layer deposition of metal (e.g., metal 405). In some cases, device 400 may depict a deposition of metal 405 over one or more elements of device 400 (e.g., over gate oxide 305). In some cases, metal 405 may range from 0.5 nm to 100 nm in thickness. In some cases, deposition of metal 405 may depict a first metal deposition of multiple metal depositions (e.g., depositions of at least two different metals).

In some cases, metal 405 may be deposited as at least a portion of a gate metal. In some cases, a gate metal, such as metal 405, may include titanium, tungsten, tantalum, titanium nitride, tungsten nitride, tantalum nitride, etc. In some cases, metal 405 may include any suitable metal that acts as a compatible layer for a second metal deposition. In some cases, deposition of metal 405 may include deposition of a thin layer of TiN. In some cases, deposition of metal 405 may include deposition of a first metal (e.g., TiN), where the first metal is deposited as a layer (e.g., protective layer, barrier metal) for deposition of a second metal (e.g., tungsten). A barrier metal, such as metal 405, may be composed of any metal (e.g., TiN) that can act as a barrier between Gate Metal (e.g., at least the second metal) and Gate Oxide (e.g., gate oxide 305).

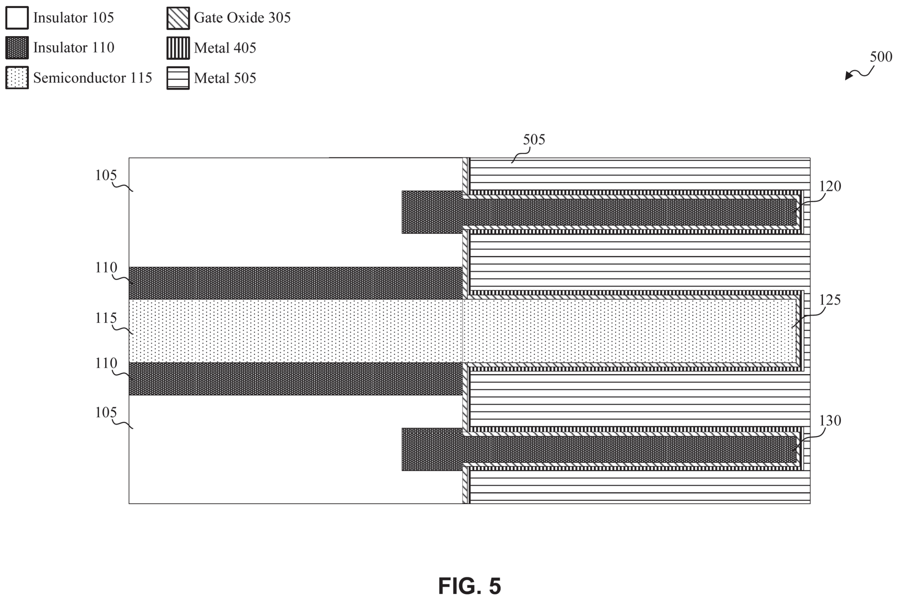

**FIG. 5** illustrates a cross-sectional view illustrating an example of a device 500 (e.g., a semiconductor device) in accordance with one or more implementations as described herein. FIG. 5 illustrates at least a portion of a semiconductor device fabrication process resulting in an improved memory cell transistor structure, enabling the systems and methods described herein of reducing an electric field (e.g., on the bitline side of a transistor) based on a thicker gate oxide formation (e.g., on the bitline side of the gate edge). In the illustrated example, device 500 may be based on device 400 of FIG. 4. In some cases, FIG. 5 may depict a cross-section (e.g., slice view) of elements of device 500 (e.g., elements of a transistor fabrication). Thus, the depicted elements may extend outward and/or may extend inward from the depicted view. Similarly, the depicted elements may repeat themselves upward and/or may repeat themselves downward from the depicted view.

In the illustrated example, device 500 may include metal 505. In some cases, device 500 may depict deposition of metal (e.g., metal 505) over one or more elements of device 400. For example, device 500 may depict selective deposition of metal 505 over portions of device 400 (e.g., over metal 405, etc.). In some cases, metal 405 and metal 505 may be part of a metal gate of device 500.

As shown, metal 505 may be deposited on metal 405 and fill up a space between inter-tier dielectric 120 and semiconductor channel 125. Similarly, metal 505 may be deposited on metal 405 and fill up a space between inter-tier dielectric 130 and semiconductor channel 125. As shown, metal 505 may be deposited on other portions of metal 405 that fill in gaps above inter-tier dielectric 120 and/or deposited on other portions of metal 405 that fill in gaps below inter-tier dielectric 130, etc.

In some cases, a first metal (e.g., metal 405, TiN) may be deposited as a barrier layer, and a second metal (e.g., metal 505, tungsten) may be deposited on the barrier layer of metal 405.

Metal 505 can be any low resistivity metal system (e.g., tungsten) that uses a barrier metal to shield gate oxide from damage. In some examples, material used for metal 505 may include tungsten, cobalt, titanium, titanium nitride, molybdenum, etc.

Using tungsten as a majority of a gate metal (e.g., using tungsten for metal 505) can significantly reduce wordline resistance for device 500 (e.g., compared to using only TiN) based on the relatively low resistivity of tungsten. Depositing metal 505 is a relatively low-cost and low-complexity fabrication process, making the deposition of metal 505 a cost-effective solution to lowering resistivity of device 500. Lowering the resistivity of device 500 helps increase switch speeds of device 500.

In some cases, device 500 may be configured as a DRAM (e.g., DRAM memory cells). Thus, increasing the switch speeds of device 500 can increase the switch speeds of DRAM. Increasing DRAM switch speeds provides faster data transfer rates, meaning the DRAM can read and write information quicker, leading to improved overall system performance, especially in memory-intensive tasks, such as artificial intelligence (AI) computing, gaming, video editing, multitasking, etc.

In some cases, the lower the resistivity, the better electrical properties of device 500. For example, the lower resistivity of metal 505 may reduce propagation delay associated with the metal 505. In some cases, metal 505 may be configured as the gate of a transistor of device 500, but may effectively act as a wire with propagation delay. By reducing the resistivity of the gate material (e.g., via lower resistivity of metal 505), the resistance of the gate of the transistor is reduced, thus improving the speed of electrical signals and increasing the switching speed of the transistor.

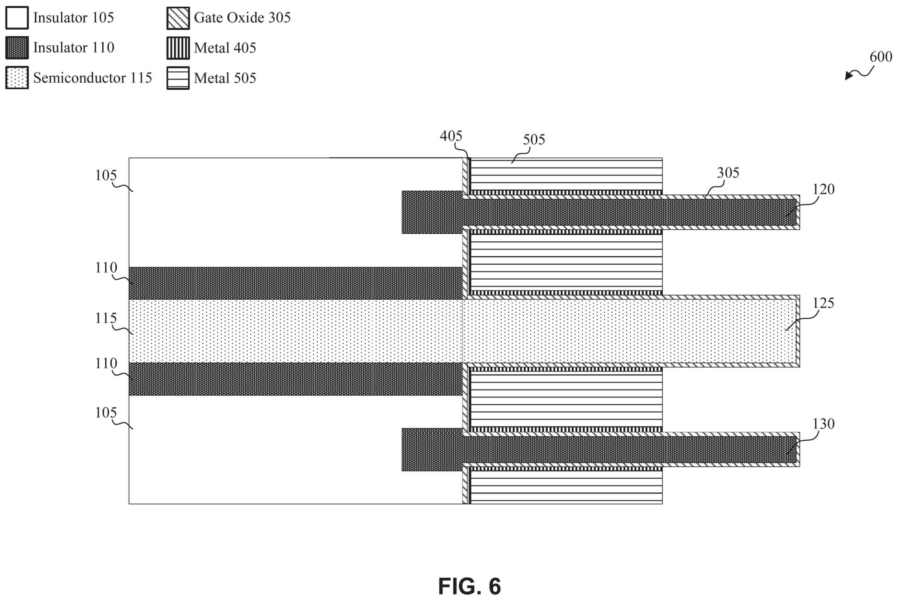

**FIG. 6** illustrates a cross-sectional view illustrating an example of a device 600 (e.g., a semiconductor device) in accordance with one or more implementations as described herein. FIG. 6 illustrates at least a portion of a semiconductor device fabrication process resulting in an improved memory cell transistor structure, enabling the systems and methods described herein of reducing an electric field (e.g., on the bitline side of a transistor) based on a thicker gate oxide formation (e.g., on the bitline side of the gate edge). In the illustrated example, device 600 may be based on device 500 of FIG. 5. In some cases, FIG. 6 may depict a cross-section (e.g., slice view) of elements of device 600 (e.g., elements of a transistor fabrication). Thus, the depicted elements may extend outward and/or may extend inward from the depicted view. Similarly, the depicted elements may repeat themselves upward and/or may repeat themselves downward from the depicted view.

In the illustrated example, device 600 may depict an etch back. In some cases, device 600 may depict an etch back of at least a portion of metal deposited on device 500. For example, device 600 may depict an etch back of metal 405 and metal 505. As shown, a portion of metal 405 and metal 505 above inter-tier dielectric 120 and/or a portion of metal 405 and metal 505 below inter-tier dielectric 120 may be etched back. Similarly, a portion of metal 405 and metal 505 above inter-tier dielectric 130 and/or a portion of metal 405 and metal 505 below inter-tier dielectric 130 may be etched back.

In the illustrated example, the etch back of metal 505 may etch the metal deposition over all exposed surfaces, leaving a remaining portion of metal 405 and metal 505. As shown, based on the etch back of metal 405 and metal 505, the right-most edges of metal 405 and metal 505 (e.g., relative to the depicted view of FIG. 6) may be etched back from the right-most edges of inter-tier dielectric 120, semiconductor channel 125, and inter-tier dielectric 130. For example, in FIG. 5, the right-most edge of metal 405 may be just beyond the right-most edges of inter-tier dielectric 120, semiconductor channel 125, and inter-tier dielectric 130, and the right-most edge of metal 505 may be just beyond the right-most edge of metal 405. However, based on the depicted etch back, the right-most edge of metal 505 may be relatively flush with the right-most edge of metal 405.

The etch back may expose a portion of gate oxide 305 over inter-tier dielectric 120, a portion of gate oxide 305 over semiconductor channel 125, and/or a portion of gate oxide 305 over inter-tier dielectric 130. As shown, metal 405 and metal 505 may be etched back to set the gate length. In some cases, the depicted etch back may be part of forming a thicker gate oxide on right side of the gate edge (e.g. relative to the depicted view of FIG. 6) that helps reduce an electric field associated with a transistor (e.g., reduce electric field on the bitline side of the transistor). After the etch back of FIG. 6, the gate length of metal 405 and metal 505 may be reduced compared to the gate length of metal 405 and metal 505 depicted in FIG. 5. For example, based on the depicted etch back, the gate length of metal 405 and metal 505 may be reduced 25-75% compared to the pre-etch-back gate length (e.g., gate length depicted in FIG. 5).

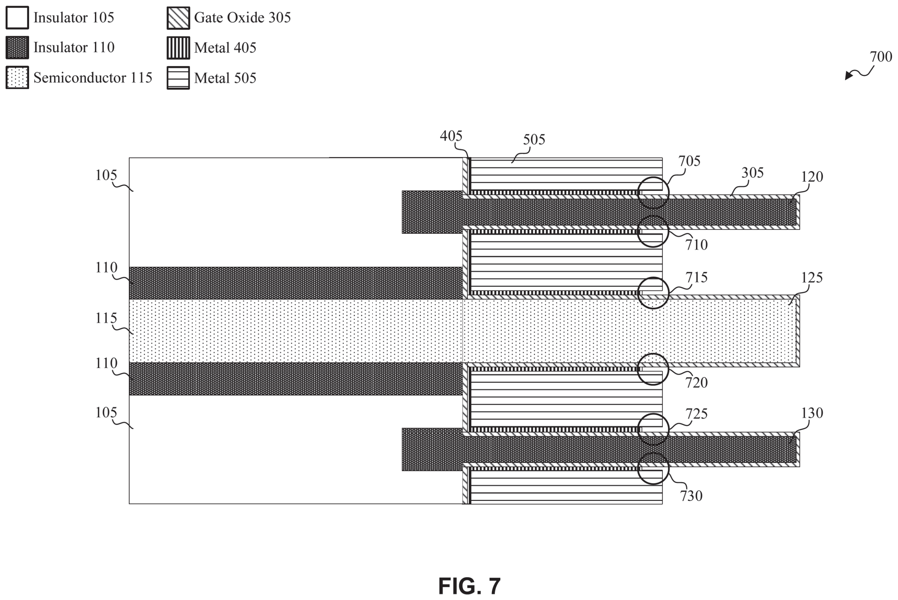

**FIG. 7** illustrates a cross-sectional view illustrating an example of a device 700 (e.g., a semiconductor device) in accordance with one or more implementations as described herein. FIG. 7 illustrates at least a portion of a semiconductor device fabrication process resulting in an improved memory cell transistor structure, enabling the systems and methods described herein of reducing an electric field (e.g., on the bitline side of a transistor) based on a thicker gate oxide formation (e.g., on the bitline side of the gate edge). In the illustrated example, device 700 may be based on device 600 of FIG. 6. In some cases, FIG. 7 may depict a cross-section (e.g., slice view) of elements of device 700 (e.g., elements of a transistor fabrication). Thus, the depicted elements may extend outward and/or may extend inward from the depicted view. Similarly, the depicted elements may repeat themselves upward and/or may repeat themselves downward from the depicted view.

In the illustrated example, device 700 may depict an etch back. In some cases, device 700 may depict an etch back of at least a portion of metal deposited on device 500. For example, device 700 may depict an etch back of metal 405 (e.g., selective etch back of the first gate metal). As shown, metal 405 may be etched back at or relatively near respective right-most edges of metal 505 based on the depicted perspective of FIG. 7.

As shown, a portion of metal 405 above inter-tier dielectric 120 may be etched back, forming recess 705. In some cases, a portion of metal 405 below inter-tier dielectric 120 may be etched back, forming recess 710. As shown, a portion of metal 405 above semiconductor channel 125 may be etched back, forming recess 715. In some cases, a portion of metal 405 below semiconductor channel 125 may be etched back, forming recess 720. As shown, a portion of metal 405 above inter-tier dielectric 130 may be etched back, forming recess 725. A portion of metal 405 below inter-tier dielectric 130 may be etched back, forming recess 730. In some cases, a portion of metal 405 above inter-tier dielectric 130 may be etched back, forming another recess similar to recess 730.

As shown, the etch back depicted in FIG. 7 may expose multiple surfaces of metal 505 based on the multiple recesses adjacent to portions of metal 505. For example, recess 705 and/or recess 710 may be formed between an exposed surface of metal 505 and a layer of gate oxide 305 over inter-tier dielectric 120. Recess 715 and/or recess 720 may be formed between an exposed surface of metal 505 and a layer of gate oxide 305 over semiconductor channel 125. Recess 725 and/or recess 730 may be formed between an exposed surface of metal 505 and a layer of gate oxide 305 over inter-tier dielectric 130.

As shown, the recesses based on the etch back depicted in FIG. 7 may be formed at the respective edges of metal 505 or relatively near respective edges of metal 505 (e.g., right-most edges). As shown, recesses may be formed on at least two sides of a given edge of metal 505. For example, from the depicted perspective of FIG. 7, one or more recesses may be formed on respective top right-most edges of metal 505 such as recess 710, recess 720, recess 730, etc. Additionally, or alternatively, recesses may be formed on respective bottom right-most edges of metal 505 such as recess 705, recess 715, recess 725, etc.

In some examples, the height of the gate metal may be based on a span of metal 505 or a span of metal 405 and metal 505. For example, based on the perspective depicted in FIG. 7, the height of the gate metal may be measured from a depicted top edge to a bottom edge of metal 505, and/or measured from a depicted top edge of metal 405 that runs along a top edge of metal 505 to a depicted bottom edge of metal 405 that runs along a bottom edge of metal 505. Based on the depicted recesses, the height of the gate metal may be reduced relatively near the right-most edges of the gate metal (e.g., of metal 505). For example, the resulting gate metal thickness at the recesses (e.g., thickness of metal 505 alone) may be less than the gate metal thickness in the portions where metal 405 remains (e.g., thickness of metal 405 and metal 505).

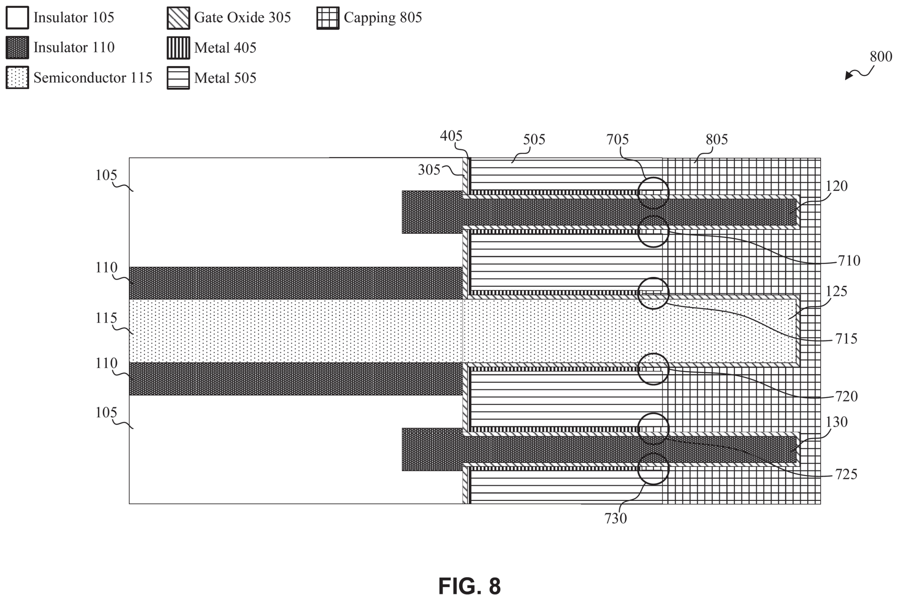

**FIG. 8** illustrates a cross-sectional view illustrating an example of a device 800 (e.g., a semiconductor device) in accordance with one or more implementations as described herein. FIG. 8 illustrates at least a portion of a semiconductor device fabrication process resulting in an improved memory cell transistor structure, enabling the systems and methods described herein of reducing an electric field (e.g., on the bitline side of a transistor) based on a thicker gate oxide formation (e.g., on the bitline side of the gate edge). In the illustrated example, device 800 may be based on device 700 of FIG. 7. In some cases, FIG. 8 may depict a cross-section (e.g., slice view) of elements of device 800 (e.g., elements of a transistor fabrication). Thus, the depicted elements may extend outward and/or may extend inward from the depicted view. Similarly, the depicted elements may repeat themselves upward and/or may repeat themselves downward from the depicted view.

In the illustrated example, device 800 may include capping 805 (e.g., spacer capping). In some cases, device 800 may depict deposition of a capping material (e.g., capping 805) over one or more elements of device 700 (e.g., gate oxide 305, over metal 405, metal 505). In some cases, capping 805 may include an insulator material (e.g., oxide insulator, nitride insulator, silicon nitride, etc.). Capping 805 may enable process steps to complete transistor device fabrication.

In the illustrated example, capping 805 may fill in spaces of device 700 that are formed based on the depicted etching of metal 405 and metal 505 in FIG. 6 and selective etching of metal 405 in FIG. 7. As shown, capping 805 may fill in multiple recesses formed based on the selective etching of metal 405 in FIG. 7 (e.g., recess 705, recess 710, recess 715, recess 720, recess 725, recess 730, etc.). As shown, capping 805 may increase an insulator thickness at an edge of the gate metal (e.g., right-most edge of metal 505 at a given recess). For example, a span between a depicted horizontal edge of inter-tier dielectric 120 and a depicted horizontal edge of the gate metal relatively near the depicted horizontal middle of the gate metal (e.g., metal 405 and metal 505) may be based on a thickness of gate oxide 305 (e.g., thickness of gate oxide 305 alone). However, a span between a depicted horizontal edge of inter-tier dielectric 120 and a depicted horizontal edge of the gate metal at a given recess (e.g., horizontal edge of metal 505 at recess 710) may be based on a thickness of gate oxide 305 and capping 805 within a given recess (e.g., gate oxide 305 and capping 805 in recess 710).

It is noted that the depicted elements of device 800 are illustrated at least for ease of identification of elements and the depicted thickness of one element (e.g., insulator 110) compared to the thickness of another element (e.g., gate oxide 305) is not necessarily depicted in a relative scale. For example, although insulator 110 is depicted as being thicker than gate oxide 305, gate oxide 305 may be thicker than insulator 110 in some implementations, etc. In some examples, gate oxide 305 may have a thickness of 5 nm (e.g., 5 nm thickness from top to bottom based on a depicted horizontal span of gate oxide 305), and capping 805 may be formed with a thickness of 10 nm in a given recess (e.g., recess 710). As a result, the thickness of gate oxide 305 and the thickness of capping 805 provide a thicker overall insulator thickness (e.g., 10 nm + 5 nm = 15 nm) at a given recess adjacent to the gate metal (e.g., metal 505 at recess 705). The thicker insulator adjacent to the gate metal at the recesses may help reduce an electric field associated with the metal gates of device 800, which can reduce leakage.

Accordingly, to reduce the rate of leakage, the insulator thickness adjacent to or relatively near the depicted recesses may be fabricated to have a greater overall insulator thickness compared to other portions of insulator thickness (e.g., thickness of gate oxide 305 near the left-to-right middle of the gate meal). This thicker insulator portion can help reduce the electric field in this region, which helps reduce leakage. By reducing leakage, the refresh rate can be reduced while still maintaining data integrity. As a result, the reduced refresh rate reduces the power draw of DRAM and increases memory cell availability. Thus, the thicker insulator improves the performance of DRAM while reducing power consumption. Moreover, keeping a remaining portion of the semiconductor channel 125 (e.g., left of the depicted recesses) with a relatively thinner insulator (e.g., gate oxide 305 alone) can help maintain the gate control and drive strength of the majority of transistor gate length.

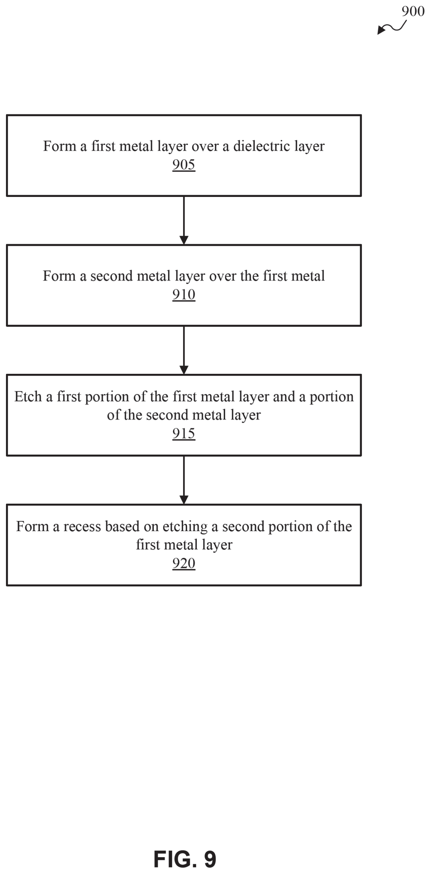

**FIG. 9** depicts a flow diagram illustrating an example method 900 associated with the disclosed systems, in accordance with example implementations described herein. In some configurations, the method 900 may be implemented by one or more semiconductor fabrication devices. The method 900 is just one implementation and one or more operations of the method 900 may be rearranged, reordered, omitted, and/or otherwise modified such that other implementations are possible and contemplated.

At 905, method 900 may include forming a first metal layer over a dielectric layer. For example, method 900 may include depositing a first metal (e.g., metal 405) over a gate dielectric layer of a transistor (e.g., gate oxide 305).

At 910, method 900 may include forming a second metal layer over the first metal layer. For example, method 900 may include forming a second metal layer (e.g., metal 505) over the first metal layer.

At 915, method 900 may include removing a portion of the first metal layer and a portion of the second metal layer. For example, method 900 may include removing a first portion of the first metal layer and a portion of the second metal layer (e.g., etching metal 405 and metal 505).

At 920, method 900 may include forming a recess based on removing a second portion of the first metal layer. For example, method 900 may include forming at least one recess (e.g., recess 705, recess 710, etc.) between the second metal layer and the dielectric layer based on selectively removing a second portion of the first metal layer (e.g., etching only the first metal layer).

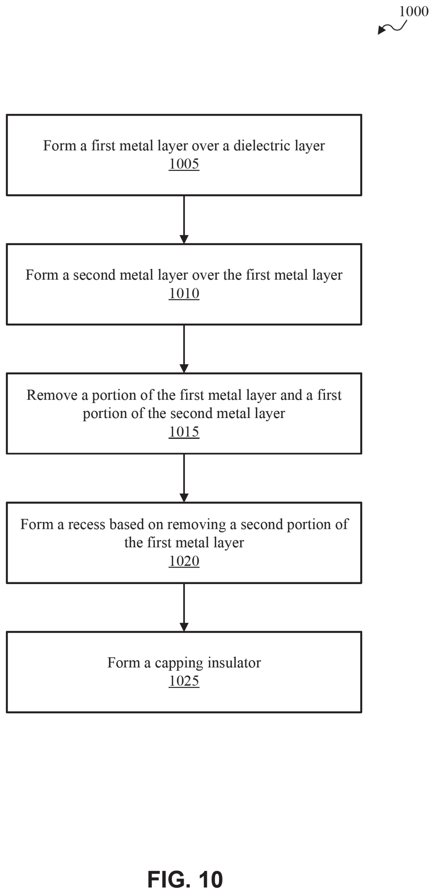

**FIG. 10** depicts a flow diagram illustrating an example method 1000 associated with the disclosed systems, in accordance with example implementations described herein. In some configurations, the method 1000 may be implemented by one or more semiconductor fabrication devices. The method 1000 is just one implementation and one or more operations of the method 1000 may be rearranged, reordered, omitted, and/or otherwise modified such that other implementations are possible and contemplated.

At 1005, method 1000 may include forming a first metal layer over a dielectric layer. For example, method 1000 may include depositing a first metal layer (e.g., metal 405) over a dielectric layer of a transistor (e.g., gate oxide 305).

At 1010, method 1000 may include forming a second metal layer over the first metal layer. For example, method 1000 may include depositing a second metal layer (e.g., metal 505) over the first metal layer.

At 1015, method 1000 may include removing a portion of the first metal layer and a portion of the second metal layer. For example, method 1000 may include removing a first portion of the first metal layer and a portion of the second metal layer (e.g., etching metal 405 and metal 505).

At 1020, method 1000 may include forming a recess based on removing a second portion of the first metal layer. For example, method 1000 may include forming at least one recess (e.g., recess 705, recess 710, etc.) between the second metal layer and the dielectric layer based on selectively removing a second portion of the first metal layer (e.g., etching only the first metal layer).

At 1025, method 1000 may include forming a capping insulator. For example, method 1000 may include depositing a capping material (e.g., insulator material, capping 805) over the first metal layer, the second metal layer, and the dielectric layer, the capping insulator material filling the at least one recess (e.g., filling in recess 705, recess 710, etc.).

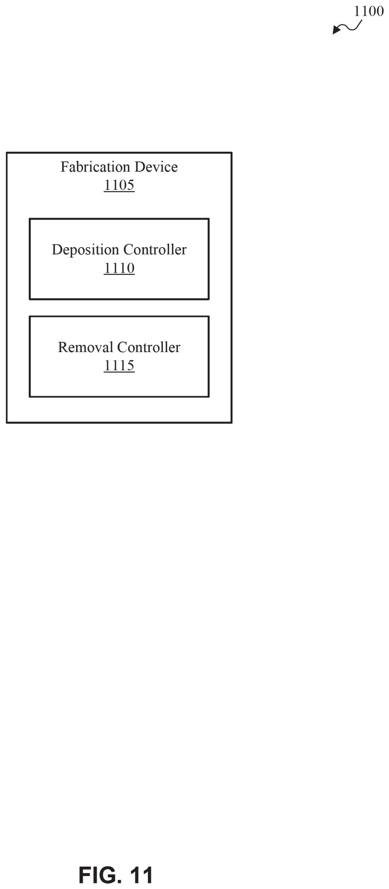

**FIG. 11** illustrates an example system 1100 in accordance with one or more implementations as described herein. As shown, system 1100 may include fabrication device 1105. Fabrication device 1105 may include any one or combination of logic (e.g., logical circuit), hardware (e.g., processing unit, memory, storage), software, firmware, and the like, that enable fabrication device 1105 to provide the systems and methods described herein of reducing an electric field (e.g., on the bitline side of a transistor) based on a thicker gate dielectric formation (e.g., on the bitline side of the gate edge).

In the illustrated example, fabrication device 1105 may include deposition controller 1110 and removal controller 1115. In some cases, deposition controller 1110 and/or removal controller 1115 may include any one or combination of logic (e.g., logical circuit), hardware (e.g., processing unit, memory, storage), software, firmware, and the like.

Deposition controller 1110 may include a control system that manages the parameters of a deposition process, where a thin layer of material is deposited onto a wafer to create the electronic components within an integrated circuit (IC). Deposition controller 1110 may regulate factors like temperature, gas flow, pressure, and plasma conditions to ensure the deposited film has the desired properties and thickness for optimal device performance. Deposition controller 1110 may provide chemical vapor deposition (CVD) where precursor gases react on the wafer surface to form a solid film; plasma enhanced CVD (PECVD) where plasma is used to enhance chemical reactions, enabling deposition at lower temperatures; and/or atomic layer deposition (ALD), where a single layer of atoms may be deposited at a time.

Removal controller 1115 may control the process of removing material from a wafer during etching, which may include dry etching and/or plasma etching, ensuring that only the desired areas are removed with the correct depth and precision to create the desired circuit features on a given chip. Removal controller 1115 may manage the rate and selectivity of material removal during the etching step.

In the examples described herein, the configurations and operations are example configurations and operations, and may involve various additional configurations and operations not explicitly illustrated. In some examples, one or more aspects of the illustrated configurations and/or operations may be omitted. In some embodiments, one or more of the operations may be performed by components other than those illustrated herein. Additionally, or alternatively, the sequential and/or temporal order of the operations may be varied.

Certain embodiments may be implemented in one or a combination of hardware, firmware, and software. Other embodiments may be implemented as instructions stored on a computer-readable storage device, which may be read and executed by at least one processor to perform the operations described herein. A computer-readable storage device may include any non-transitory memory mechanism for storing information in a form readable by a machine (e.g., a computer). For example, a computer-readable storage device may include read-only memory (ROM), random-access memory (RAM), magnetic disk storage media, optical storage media, flash-memory devices, and other storage devices and media.

The word "exemplary" may be used herein to mean "serving as an example, instance, or illustration." Any embodiment described herein as "exemplary" is not necessarily to be construed as preferred or advantageous over other embodiments.

Although an example processing system has been described above, embodiments of the subject matter and the functional operations described herein can be implemented in other types of digital electronic circuitry, or in computer software, firmware, or hardware, including the structures disclosed in this specification and their structural equivalents, or in combinations of one or more of them.

Embodiments of the subject matter and the operations described herein can be implemented in digital electronic circuitry, or in computer software, firmware, or hardware, including the structures disclosed in this specification and their structural equivalents, or in combinations of one or more of them. Embodiments of the subject matter described herein can be implemented as one or more computer programs, i.e., one or more components of computer program instructions, encoded on computer storage medium for execution by, or to control the operation of, information/data processing apparatus. Alternatively, or in addition, the program instructions can be encoded on an artificially-generated propagated signal, for example a machine-generated electrical, optical, or electromagnetic signal, which is generated to encode information/data for transmission to suitable receiver apparatus for execution by an information/data processing apparatus. A computer storage medium can be, or be included in, a computer-readable storage device, a computer-readable storage substrate, a random or serial access memory array or device, or a combination of one or more of them. Moreover, while a computer storage medium is not a propagated signal, a computer storage medium can be a source or destination of computer program instructions encoded in an artificially-generated propagated signal. The computer storage medium can also be, or be included in, one or more separate physical components or media (for example multiple CDs, disks, or other storage devices).

The operations described herein can be implemented as operations performed by an information/data processing apparatus on information/data stored on one or more computer-readable storage devices or received from other sources.

The term "data processing apparatus" encompasses all kinds of apparatus, devices, and machines for processing data, including by way of example a programmable processor, a computer, a system on a chip, or multiple ones, or combinations, of the foregoing. The apparatus can include special purpose logic circuitry, for example an FPGA (field programmable gate array) or an ASIC (application-specific integrated circuit). The apparatus can also include, in addition to hardware, code that creates an execution environment for the computer program in question, for example code that constitutes processor firmware, a protocol stack, a database management system, an operating system, a cross-platform runtime environment, a virtual machine, or a combination of one or more of them. The apparatus and execution environment can realize various different computing model infrastructures, such as web services, distributed computing and grid computing infrastructures.

A computer program (also known as a program, software, software application, script, or code) can be written in any form of programming language, including compiled or interpreted languages, declarative or procedural languages, and it can be deployed in any form, including as a stand-alone program or as a component, component, subroutine, object, or other unit suitable for use in a computing environment. A computer program may, but need not, correspond to a file in a file system. A program can be stored in a portion of a file that holds other programs or information/data (for example one or more scripts stored in a markup language document), in a single file dedicated to the program in question, or in multiple coordinated files (for example files that store one or more components, sub-programs, or portions of code). A computer program can be deployed to be executed on one computer or on multiple computers that are located at one site or distributed across multiple sites and interconnected by a communication network.

The processes and logic flows described herein can be performed by one or more programmable processors executing one or more computer programs to perform actions by operating on input information/data and generating output. Processors suitable for the execution of a computer program include, by way of example, both general and special purpose microprocessors, and any one or more processors of any kind of digital computer. Generally, a processor will receive instructions and information/data from a read-only memory or a random-access memory or both. The essential elements of a computer are a processor for performing actions in accordance with instructions and one or more memory devices for storing instructions and data. Generally, a computer will also include, or be operatively coupled to receive information/data from or transfer information/data to, or both, one or more mass storage devices for storing data, for example magnetic, magneto-optical disks, or optical disks. However, a computer need not have such devices. Devices suitable for storing computer program instructions and information/data include all forms of non-volatile memory, media and memory devices, including by way of example semiconductor memory devices, for example EPROM, EEPROM, and flash memory devices; magnetic disks, for example internal hard disks or removable disks; magneto-optical disks; and CD-ROM and DVD-ROM disks. The processor and the memory can be supplemented by, or incorporated in, special purpose logic circuitry.

Embodiments of the subject matter described herein can be implemented in a computing system that includes a back-end component, for example as an information/data server, or that includes a middleware component, for example an application server, or that includes a front-end component, for example a client computer having a graphical user interface or a web browser through which a user can interact with an embodiment of the subject matter described herein, or any combination of one or more such back-end, middleware, or front-end components. The components of the system can be interconnected by any form or medium of digital information/data communication, for example a communication network. Examples of communication networks include a local area network ("LAN") and a wide area network ("WAN"), an inter-network (for example the Internet), and peer-to-peer networks (for example ad hoc peer-to-peer networks).

The computing system can include clients and servers. A client and server are generally remote from each other and typically interact through a communication network. The relationship of client and server arises by virtue of computer programs running on the respective computers and having a client-server relationship to each other. In some embodiments, a server transmits information/data (for example an HTML page) to a client device (for example for purposes of displaying information/data to and receiving user input from a user interacting with the client device). Information/data generated at the client device (for example a result of the user interaction) can be received from the client device at the server.

While this specification contains many specific embodiment details, these should not be construed as limitations on the scope of any embodiment or of what may be claimed, but rather as descriptions of features specific to particular embodiments. Certain features that are described herein in the context of separate embodiments can also be implemented in combination in a single embodiment. Conversely, various features that are described in the context of a single embodiment can also be implemented in multiple embodiments separately or in any suitable sub-combination. Moreover, although features may be described above as acting in certain combinations and even initially claimed as such, one or more features from a claimed combination can in some cases be excised from the combination, and the claimed combination may be directed to a sub-combination or variation of a sub-combination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described. Other embodiments are within the scope of the following claims. In some cases, the actions recited in the claims can be performed in a different order and still achieve desirable results. In addition, the processes depicted in the accompanying figures do not necessarily require the particular order shown, or sequential order, to achieve desirable results. In certain embodiments, multitasking and parallel processing may be advantageous.

Many modifications and other examples as set forth herein will come to mind to one skilled in the art to which these embodiments pertain having the benefit of the teachings presented in the foregoing descriptions and the associated drawings. Therefore, it is to be understood that the embodiments are not to be limited to the specific embodiments disclosed and that modifications and other embodiments are intended to be included within the scope of the appended claims. Although specific terms are employed herein, they are used in a generic and descriptive sense only and not for purposes of limitation.

## Claims

1. A method of fabrication of a transistor of a memory cell, the method comprising:
forming a first insulator (105), a second insulator (110), and a semiconductor channel (125) of the transistor;
forming a dielectric layer (305) over at least one of a surface of the first insulator (105), a surface of the second insulator (110), and a surface of the semiconductor channel (125);
forming a first metal layer (405) over the dielectric layer (305);
forming a second metal layer (505) over the first metal layer (405);
removing a first portion of the first metal layer (405) and a portion of the second metal layer (505); and
forming at least one recess (705, 710, 715, 720, 725, 730) between the second metal layer (505) and the dielectric layer (305) based on removing a second portion of the first metal layer (405).

2. The method of claim 1, wherein the at least one recess (705, 710, 715, 720, 725, 730) includes a first recess formed between an exposed surface of the second metal layer (505) and a first portion of the dielectric layer (305) formed over a first inter-tier dielectric (120) that extends out from a first portion of the first insulator (105).

3. The method of claim 1 or 2, wherein the at least one recess (705, 710, 715, 720, 725, 730) includes at least one of:
a second recess (715, 720) formed between an exposed surface of the second metal layer (505) and a second portion of the dielectric layer (305) formed over the semiconductor channel (125), and
a third recess (725, 730) formed between an exposed surface of the second metal layer (505) and a third portion of the dielectric layer (305) formed over a second inter-tier dielectric (130) that extends out from a second portion of the first insulator (105).

4. The method of any one of claims 1 to 3, wherein forming the second metal layer (505) comprises a deposition fill that fills multiple gaps with the second metal layer (505).

5. The method of claim 1, wherein forming the second metal layer (505) comprises a deposition fill that fills multiple gaps with the second metal layer (505), and
wherein the multiple gaps comprise a first gap above a first inter-tier dielectric (120), a second gap between the first inter-tier dielectric (120) and the semiconductor channel (125), a third gap between the semiconductor channel (125) and a second inter-tier dielectric (130), and a fourth gap below the second inter-tier dielectric (130).

6. The method of any one of claims 1 to 5, wherein the dielectric layer (305) is formed as a gate oxide of the transistor.

7. The method of any one of claims 1 to 6, further comprising forming a capping insulator material (805) over the first metal layer (405), the second metal layer (505), and the dielectric layer (305), the capping insulator material (805) filling the at least one recess (705, 710, 715, 720, 725, 730).

8. The method of claim 7, wherein at least one of the capping insulator material (805), the first insulator (105), and the second insulator (110) comprise at least one of a nitride insulator or an oxide insulator.

9. The method of any one of claims 1 to 8, wherein forming the first metal layer (405) comprises forming a thin layer of the first metal layer (405) over the dielectric layer (305), at least one of the dielectric layer (305) or the first metal layer (405) having a thickness within a range of 0.5 nm to 20 nm.

10. The method of any one of claims 1 to 9, wherein:
at least a portion of the second insulator (110) is formed adjacent to the first insulator (105) and a semiconductor (115) that includes the semiconductor channel (125).

11. A transistor of a memory cell comprising:
a first insulator (105), a second insulator (110), and a semiconductor channel (125);
a dielectric layer (305) formed over at least one of a surface of the first insulator (105), a surface of the second insulator (110), or a surface of the semiconductor channel (125);
a first metal layer (405) formed over the dielectric layer (305);
a second metal layer (505) formed over the first metal layer (405);
at least one gap formed based on a first etch back of a first portion of the first metal layer (405) and a portion of the second metal layer (505); and
at least one recess (705, 710, 715, 720, 725, 730) formed between the second metal layer (505) and the dielectric layer (305) based on a second etch back of a second portion of the first metal layer (405).

12. The transistor of claim 11, wherein the at least one recess (705, 710, 715, 720, 725, 730) includes a first recess (705, 710) formed between an exposed surface of the second metal layer (505) and a first portion of the dielectric layer (305) formed over a first inter-tier dielectric (120) that extends out from a first portion of the first insulator (105).

13. The transistor of claim 11 or 12, wherein the at least one recess (705, 710, 715, 720, 725, 730) includes at least one of:
a second recess (715, 720) formed between an exposed surface of the second metal layer (505) and a second portion of the dielectric layer (305) formed over the semiconductor channel (725), and
a third recess (725, 730) formed between an exposed surface of the second metal layer (505) and a third portion of the dielectric layer (305) formed over a second inter-tier dielectric (130) that extends out from a second portion of the first insulator (105).

14. The transistor of claim 11, wherein the at least one gap comprises a first gap above a first inter-tier dielectric (120)), a second gap between the first inter-tier dielectric (120) and the semiconductor channel (125), a third gap between the semiconductor channel (125) and a second inter-tier dielectric (130), and a fourth gap below the second inter-tier dielectric (130).

15. The transistor of any one of claims 11 to 14, wherein the transistor further includes a capping insulator material (805) formed over the first metal layer (405), the second metal layer (505), and the dielectric layer (305), the capping insulator material (805) filling the at least one recess (705, 710, 715, 720, 725, 730).
